# EUROPEAN PATENT APPLICATION

(11) **EP 4 577 027 A1**
(43) Date of publication of application: **25.06.2025**
(21) Application number: 23862969.5
(22) Date of filing: 25.08.2023
(51) Int. Cl.: H10N 10/17

(54) **THERMOELECTRIC CONVERSION MODULE**

(30) Priority: 09.09.2022 JP 2022143637
(71) Applicant: Denka Company Limited, Tokyo 103-8338 (JP)
(72) Inventor: ASAMI, Takeshi, Tokyo 103-8338 (JP); NIWA, Ryota, Tokyo 103-8338 (JP); MAEDA, Ryota, Tokyo 103-8338 (JP)
(74) Representative: Gulde & Partner
(86) International application number: PCT/JP2023/030750
(87) International publication number: WO 2024/053430

(57) **Abstract**

The thermoelectric conversion module includes a substrate having a first main face and a second main face located opposite the first main face, a thermoelectric conversion part located on the first main face, and a capacitor provided on the second main face and thermally exchangeable with the thermoelectric conversion part via the substrate and electrically connected to the thermoelectric conversion part, the substrate, the thermoelectric conversion part, and the capacitor overlap each other in a thickness direction of the substrate, and the capacitor includes a plurality of electrodes stacked each other in the thickness direction and a dielectric filling gaps between the plurality of electrodes and exhibiting heat resistance.

## Description

### Technical Field

The present disclosure relates to a thermoelectric conversion module.

### Background Art

A thermoelectric conversion element may be used to perform power generation using geothermal heat, exhaust heat of a factory, or the like. Patent Document 1 discloses an embodiment in which a flexible substrate having a pattern layer composed of resin layers and metal layers is provided on both surfaces of a thermoelectric conversion module having a P-type thermoelectric element material and an N-type thermoelectric element material. In Patent Document 1, a metal layer included in one flexible substrate overlaps one electrode included in the thermoelectric conversion module, and a metal layer included in the other flexible substrate overlaps the other electrode included in the thermoelectric conversion module. In the above embodiment, by setting one flexible substrate to a high temperature state and setting the other flexible substrate to a low temperature state, a temperature difference is generated in a planar direction of the thermoelectric conversion module. Accordingly, an electromotive force is generated in the thermoelectric conversion module.

### Citation List

### Patent Literature

[Patent Document 1] Japanese Patent No. 4,895,293

### Summary of Invention

### Technical Problem

For example, in electronic devices that use the thermoelectric conversion module described in Patent Document 1 as a power source, the thermoelectric conversion module may be connected to a capacitor for power storage. Here, if the thermoelectric conversion module and the capacitor are simply arranged side by side, it may lead to an increase in the size of the electronic device.

An object of one aspect of the present disclosure is to provide a thermoelectric conversion module capable of maintaining the function of a power source while suppressing the increase in size of the power source.

### Solution to Problem

A thermoelectric conversion module according to one aspect of the present disclosure is as follows.
[1] A thermoelectric conversion module includes a substrate having a first main face and a second main face located opposite the first main face, a thermoelectric conversion part located on the first main face, and a capacitor provided on the second main face and thermally exchangeable with the thermoelectric conversion part via the substrate and electrically connected to the thermoelectric conversion part, wherein the substrate, the thermoelectric conversion part, and the capacitor overlap each other in a thickness direction of the substrate, and the capacitor includes a plurality of electrodes stacked each other in the thickness direction, and a dielectric filling gaps between the plurality of electrodes and exhibiting heat resistance.
[2] The thermoelectric conversion module according to [1], wherein the capacitor has flexibility.
[3] The thermoelectric conversion module according to [1] or [2], further includes a thermal insulating member located on the second main face, wherein the thermoelectric conversion part has a p-type thermoelectric conversion element and an n-type thermoelectric conversion element arranged along a first direction orthogonal to the thickness direction, a first end part of the p-type thermoelectric conversion element in the first direction is in contact with a first end part of the n-type thermoelectric conversion element in the first direction and overlaps with the thermal insulating member in the thickness direction, the capacitor includes a first capacitor and a second capacitor adjacent to each other with the thermal insulating member therebetween along the first direction, the first capacitor and the second capacitor being in contact with the second main face, in the thickness direction, the first capacitor overlaps with a second end part of the n-type thermoelectric conversion element in the first direction, and, in the thickness direction, the second capacitor overlaps with a second end part of the p-type thermoelectric conversion element in the first direction.
[4] The thermoelectric conversion module according to [3], wherein the capacitor further includes a sheet capacitor overlapping the first capacitor and the second capacitor in the thickness direction, the sheet capacitor being electrically connected to the thermoelectric conversion part.
[5] The thermoelectric conversion module according to [4], wherein the sheet capacitor is in contact with the first capacitor and the second capacitor and spaced apart from the thermal insulating member.
[6] The thermoelectric conversion module according to [1] or [2], further includes a thermal insulating member located on the second main face, and a first thermal conduction part and a second thermal conduction part adjacent to each other with the thermal insulating member therebetween along a first direction orthogonal to the thickness direction, wherein the thermoelectric conversion part has a p-type thermoelectric conversion element and an n-type thermoelectric conversion element arranged along the first direction, a first end part of the p-type thermoelectric conversion element in the first direction is in contact with a first end part of the n-type thermoelectric conversion element in the first direction and overlaps with the thermal insulating member in the thickness direction, in the thickness direction, the first thermal conduction part overlaps with a second end part of the n-type thermoelectric conversion element in the first direction, in the thickness direction, the second thermal conduction part overlaps with a second end part of the p-type thermoelectric conversion element in the first direction, and the capacitor is thermally exchangeable with the thermoelectric conversion part via the substrate and at least one of the first thermal conduction part and the second thermal conduction part.
[7] The thermoelectric conversion module according to [6], wherein the capacitor is a sheet capacitor overlapping the first thermal conduction part and the second thermal conduction part in the thickness direction, and the sheet capacitor is in contact with the first thermal conduction part and the second thermal conduction part, the sheet capacitor being spaced apart from the thermal insulating member.
[8] The thermoelectric conversion module according to any one of [1] to [7], further includes a connection part located on the substrate and electrically connected to both the thermoelectric conversion part and the capacitor.
[9] The thermoelectric conversion module according to any one of [1] to [8], wherein each thermal conductivity of the plurality of electrodes and the dielectric is 3 W/mK or more.

### Advantageous Effects of Invention

According to one aspect of the present disclosure, a thermoelectric conversion module capable of maintaining the function of a power source while suppressing the increase in size of the power source can be provided.

### Brief Description of Drawings

[FIG. 1] (a) of FIG. 1 is a schematic plan view illustrating a thermoelectric conversion module according to an embodiment, and (b) of FIG. 1 is a schematic bottom view illustrating the thermoelectric conversion module according to an embodiment.
[FIG. 2] (a) of FIG. 2 is an enlarged view of a part (a region surrounded by an alternate long and short dash line) of (a) of FIG. 1, and (b) of FIG. 2 is a cross-sectional view taken along line IIb-IIb of (a) of FIG. 2.
[FIG. 3] (a) of FIG. 3 is a cross-sectional view taken along line IIIa-IIIa of (a) of FIG. 1, and (b) of FIG. 3 is a cross-sectional view taken along line IIIb-IIIb of (a) of FIG. 1.
[FIG. 4] (a) of FIG. 4 is a schematic bottom view illustrating a thermoelectric conversion module according to a first modification, and (b) of FIG. 4 is a cross-sectional view taken along line IVb-IVb of (a) of FIG. 4.
[FIG. 5] FIG. 5 is a cross-sectional view of a main part of a thermoelectric conversion module according to a second modification.

### Description of Embodiments

Hereinafter, an embodiment of the present disclosure will be described in detail with reference to the accompanying drawings. In the following description, the same reference numerals are used for the same element or element having the same function, and redundant description is omitted. In the present specification, "identical" and words similar thereto are not limited to "completely identical".

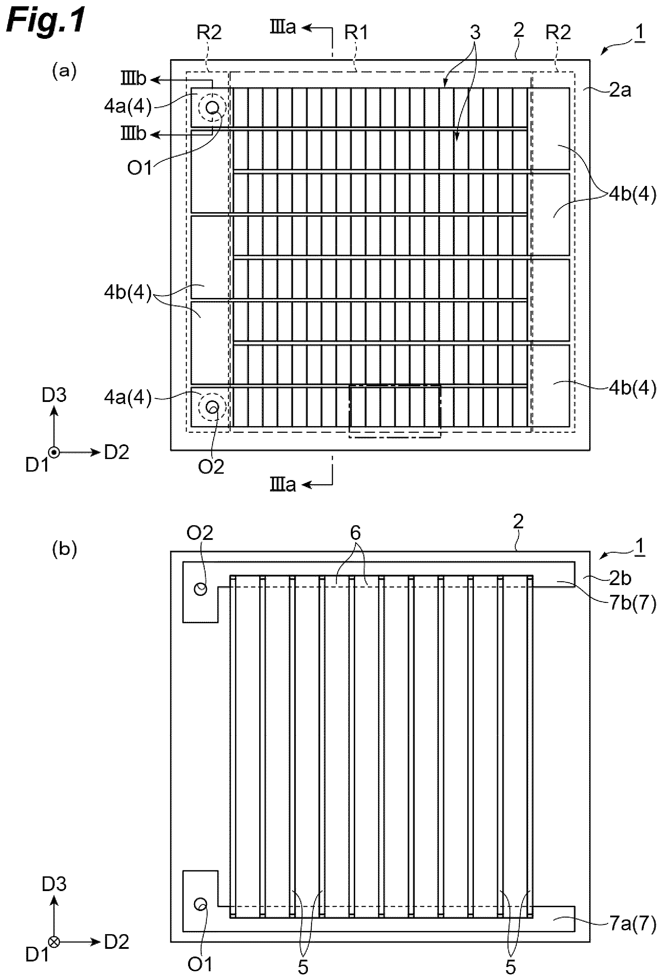

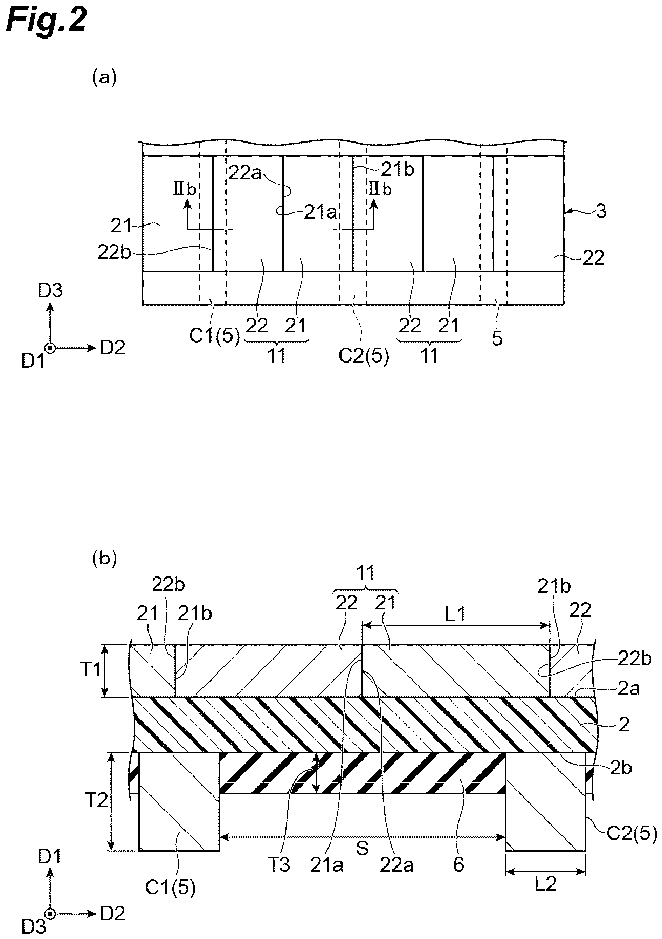

First, a configuration of a thermoelectric conversion module according to the present embodiment will be described with reference to FIGS. 1 and 2. (a) of FIG. 1 is a schematic plan view showing the thermoelectric conversion module according to the present embodiment, and (b) of FIG. 1 is a schematic bottom view showing the thermoelectric conversion module according to the present embodiment. (a) of FIG. 2 is an enlarged view of a part (a region surrounded by an alternate long and short dash line) of (a) of FIG. 1. (b) of FIG. 2 is a cross-sectional view taken along line IIb-IIb of (a) of FIG. 2.

A thermoelectric conversion module 1 shown in (a) and (b) of FIG. 1 is a device capable of generating power by being supplied with heat from the outside. The thermoelectric conversion module 1 is a so-called in-plane type device. Thus, the thermoelectric conversion module 1 is likely to be more excellent in workability and flexibility than, for example, a π-type element (cross-plane type element). Therefore, the thermoelectric conversion module 1 can be provided along the side surface of a cylindrical pipe or the like used for recovering factory exhaust heat, for example. That is, the thermoelectric conversion module 1 can be easily disposed at various positions. Therefore, the thermoelectric conversion module 1 is used, for example, as a power source for electronic devices such as plant sensors using exhaust heat. In addition, the contact resistance between the thermoelectric conversion material and the electrode included in the thermoelectric conversion module 1 is likely to be lower than that of the π-type module. In the following, the temperature of each component of the thermoelectric conversion module 1 is measured under natural convection conditions of air.

The thermoelectric conversion module 1 includes a substrate 2, a plurality of thermoelectric conversion groups 3, a plurality of conductive parts 4, a plurality of thermal conduction parts 5, a plurality of thermal insulating members 6, and a connection part 7. At least one of the substrate 2, the plurality of thermoelectric conversion groups 3, the plurality of conductive parts 4, the plurality of thermal conduction parts 5, the plurality of thermal insulating members 6, and the connection part 7 shows flexibility.

The substrate 2 is a sheet member made of a resin showing heat resistance and flexibility, and, for example, has a substantially flat plate shape. Examples of the resin constituting the substrate 2 include a (meth)acrylic based resin, a (meth)acrylonitrile based resin, a polyamide based resin, a polycarbonate based resin, a polyether based resin, a polyester based resin, an epoxy based resin, an organosiloxane based resin, a polyimide based resin, and a polysulfone based resin. The thickness of the substrate 2 is, for example, 5 µm or more and 50 µm or less. The thermal conductivity of the substrate 2 is, for example, 0.1 W/mK (corresponding to 0.1 watts per meter per Kelvin and 0.1 W×m⁻¹×K⁻¹) or more and 0.3 W/mK or less. The thermal conductivity of the substrate 2 is 0.3 W/mK or less, so that a temperature difference can occur inside the thermoelectric conversion group 3. The thermal conductivity of the substrate 2 is measured by a steady state method or a non-steady state method.

The substrate 2 has a first main face 2a and a second main face 2b located on the opposite side of the first main face 2a. The first main face 2a and the second main face 2b are surfaces intersecting with a direction along the thickness of the substrate 2. The shapes of the first main face 2a and the second main face 2b is not particularly limited, and are, for example, a polygonal shape, a circular shape, an elliptical shape or the like. Hereinafter, a direction along the thickness of the substrate 2 is simply referred to as a thickness direction D1. Viewing from the thickness direction D1 corresponds to a plan view. Further, directions orthogonal to the thickness direction D1 are referred to as a first direction D2 and a second direction D3. The second direction D3 is a direction orthogonal to both the thickness direction D1 and the first direction D2.

A thermoelectric conversion region R1 and two conductive regions R2 are defined on the first main face 2a. The plurality of thermoelectric conversion groups 3 are provided in the thermoelectric conversion region R1. The plurality of conductive parts 4 are provided in each conductive region R2. The thermoelectric conversion region R1 is located between the two conductive regions R2 in the first direction D2. The higher the percentage of the thermoelectric conversion region R1 occupied on the first main face 2a, the higher output of the thermoelectric conversion module 1 is likely to be. In a plan view, the thermoelectric conversion region R1 accounts for, for example, 50% or more and 90% or less, in the area of the first main face 2a. In a plan view, the two conductive regions R2 accounts for, for example, 5% or more and 30% or less, in the area of the first main face 2a. In this case, the thermoelectric conversion module 1 can exhibit excellent output while reliably forming a conductive path connecting the thermoelectric conversion groups 3 to each other.

The substrate 2 is provided with openings O1 and O2 functioning as through holes. Each of the openings O1 and O2 is an opening portion extending from the first main face 2a to the second main face 2b. The conductive parts 4 and the connection part 7 are electrically connected via a conductive material provided on the surface of the openings O1 and O2 (details will be described later).

Each of the plurality of thermoelectric conversion groups 3 is a portion capable of generating power by being supplied with heat from the outside, and is located on the first main face 2a. The thermoelectric conversion groups 3 extend along the first direction D2 and are arranged along the second direction D3. Each of the thermoelectric conversion groups 3 has a band shape when viewed from the thickness direction D1. Each thermoelectric conversion group 3 is electrically connected to each other in series while being spaced apart from each other. In the first direction D2, one end of each thermoelectric conversion group 3 is connected to one of the plurality of conductive parts 4 included in one conductive region R2, and the other end of each thermoelectric conversion group 3 is connected to one of the plurality of conductive parts 4 included in the other conductive region R2. As shown in (a) of FIG. 2, each of the plurality of thermoelectric conversion groups 3 includes a plurality of thermoelectric conversion parts 11. In the present embodiment, each thermoelectric conversion group 3 includes ten thermoelectric conversion parts 11, but is not limited thereto. In each thermoelectric conversion group 3, the plurality of thermoelectric conversion parts 11 are arranged along the first direction D2. Two thermoelectric conversion parts 11 adjacent to each other in the first direction D2 are in contact with each other and are connected in series.

Each of the plurality of thermoelectric conversion parts 11 is a part in which thermoelectric conversion is performed in the thermoelectric conversion module 1, and has a flexibility. The shape of the thermoelectric conversion part 11 in a plan view is not particularly limited, and is, for example, a polygonal shape, a circular shape, an elliptical shape or the like. A p-type thermoelectric conversion element 21 and an n-type thermoelectric conversion element 22 have an identical shape as each other, but are not limited thereto. Each thermoelectric conversion part 11 has the p-type thermoelectric conversion element 21 and the n-type thermoelectric conversion element 22 arranged along the first direction D2. In each thermoelectric conversion part 11, a first end part 21a of the p-type thermoelectric conversion element 21 in the first direction D2 and a first end part 22a of the n-type thermoelectric conversion element 22 in the first direction D2 are in contact with each other. In each thermoelectric conversion part 11, a second end part 21b of the p-type thermoelectric conversion element 21 in the first direction D2 is located at one end of the corresponding thermoelectric conversion part 11, and a second end part 22b of the n-type thermoelectric conversion element 22 in the first direction D2 is located at the other end of the corresponding thermoelectric conversion part 11. In two thermoelectric conversion parts 11 adjacent to each other in the first direction D2, the second end part 21b of the p-type thermoelectric conversion element 21 included in one thermoelectric conversion part 11 and the second end part 22b of the n-type thermoelectric conversion element 22 included in the other thermoelectric conversion part 11 are in contact with each other.

In each of the plurality of thermoelectric conversion groups 3, the p-type thermoelectric conversion element 21 and the n-type thermoelectric conversion element 22 are alternately arranged in the first direction D2. In the present embodiment, the p-type thermoelectric conversion element 21 and the n-type thermoelectric conversion element 22 are alternately arranged in the second direction D3.

The p-type thermoelectric conversion element 21 is provided on the first main face 2a of the substrate 2 and in contact with the n-type thermoelectric conversion element 22. The thickness T1 of the p-type thermoelectric conversion element 21 is, for exam ple, 3 µm or more and 30 µm or less. Since the thickness T1 is 3 µm or more, the electric resistance of the p-type thermoelectric conversion element 21 can be favorably reduced. Since the thickness T1 is 30 µm or less, a temperature gradient can be easily formed inside the p-type thermoelectric conversion element 21. The thickness T1 may be 5 µm or more, 8 µm or more, 10 µm or more, 25 µm or less, 20 µm or less, or 15 µm or less. The length L1 of the p-type thermoelectric conversion element 21 in the first direction D2 is, for example, 2 mm or more and 10 mm or less. In this case, a temperature gradient can be easily formed inside the p-type thermoelectric conversion element 21. The length of the p-type thermoelectric conversion element 21 in the second direction D3 is, for example, 5 mm or more and 30 mm or less. In this case, a sufficient number of thermoelectric conversion parts 11 can be formed on the first main face 2a. The thermal conductivity of the p-type thermoelectric conversion element 21 in the in-plane direction is, for example, 0.01 W/mK or more and 40.0 W/mK or less. The thermal conductivity of the p-type thermoelectric conversion element 21 in the in-plane direction is measured by, for example, an optical alternating current method or a 3-omega method. The p-type thermoelectric conversion element 21 is formed by, for example, various dry methods or wet methods. Examples of the wet method include a doctor blade method, a dip coating method, a spray coating method, a spin coating method, and an ink jet method or the like.

The p-type thermoelectric conversion element 21 is, for example, a p-type semiconductor layer. The p-type thermoelectric conversion element 21 includes, for example, carbon nanotubes (CNTs) and conductive resins different from the carbon nanotubes. The carbon nanotube exhibits p-type. The carbon nanotube may be single-walled, double-walled or multi-walled. From the viewpoint of the electrical conductivity of the p-type thermoelectric conversion element 21, single-walled carbon nanotubes (SWCNTs) may be used. The percentage of the single-walled carbon nanotubes in the total amount of the carbon nanotubes may be 25% by mass or more, 50% by mass or more, or 100% by mass. The diameter of the single-walled carbon nanotube is not particularly limited, and is, for example, 20 nm or less, 10 nm or less, or 3 nm or less. The lower limit of the diameter of the single-walled carbon nanotube is also not particularly limited, but may be 0.4 nm or more, or may be 0.5 nm or more. The thermal conductivity of the carbon nanotube is, for example, 30 W/mK or more and 40 W/mK or less.

In the present specification, the diameter of the single-walled carbon nanotube can be determined by formula: "Diameter (nm) = 248/ω)" using the wave number (ω (cm⁻¹)) of a peak appearing at 100 to 300 cm⁻¹ by Raman spectroscopy. As a method for evaluating the single-walled carbon nanotube, a G/D ratio in laser Raman spectroscopy is known. In the present embodiment, the G/D ratio of the single-walled carbon nanotube in laser Raman spectroscopy at a wavelength of 532 nm may be 10 or more or 20 or more. By using such a single-walled carbon nanotube, there is a tendency that the p-type thermoelectric conversion element 21 having further excellent electrical conductivity is obtained. Note that, the upper limit of the G/D ratio is not particularly limited, and may be, 500 or less or 300 or less.

The content of the carbon nanotubes in the p-type thermoelectric conversion element 21 may be, for example, 20 parts by mass or more, 30 parts by mass or more, 40 parts by mass or more, 99 parts by mass or less, 95 parts by mass or less, or 90 parts by mass or less, with respect to 100 parts by mass of the material (p-type thermoelectric conversion material) configuring the p-type thermoelectric conversion element 21.

The conductive resin of the present embodiment is not particularly limited, and a known conductive resin can be used without particular limitation. Examples of the conductive resin include those including a polyaniline-based conductive resin, a polythiophene-based conductive resin, a polypyrrole-based conductive resin, a polyacetylene-based conductive resin, a polyphenylene-based conductive resin, a polyphenylenevinylene-based conductive resin and the like. As the polythiophene-based conductive resin, poly (3, 4-ethylenedioxythiophene) (PEDOT) can be exemplified. In the present embodiment, the conductive resin includes PEDOT and an electron acceptor. In this case, there is a tendency that the electrical conductivity of the p-type thermoelectric conversion element 21 is further enhanced. Examples of the electron acceptor include polystyrene sulfonic acid, polyvinyl sulfonic acid, poly (meth)acrylic acid, polyvinyl sulfonic acid, toluenesulfonic acid, dodecylbenzenesulfonic acid, camphorsulfonic acid, bis(2-ethylhexyl) sulfosuccinate, chlorine, bromine, iodine, phosphorus pentafluoride, arsenic pentafluoride, boron trifluoride, hydrogen chloride, sulfuric acid, nitric acid, tetrafluoroboric acid, perchloric acid, iron(III) chloride, tetracyanoquinodimethane and the like. In view of the electrical conductivity of the p-type thermoelectric conversion element 21, the electron acceptor may be polystyrene sulfonic acid (PSS).

In the p-type thermoelectric conversion element 21, the carbon nanotube and the conductive resin may aggregate. The p-type thermoelectric conversion element 21 may include a porous structure in which carbon nanotubes are bonded to each other by the conductive resin.

The n-type thermoelectric conversion element 22 is provided on the first main face 2a of the substrate 2 and is in contact with the p-type thermoelectric conversion element 21. The thickness of the n-type thermoelectric conversion element 22 is identical to or substantially identical to the thickness T1 of the p-type thermoelectric conversion element 21. The length of the n-type thermoelectric conversion element 22 in the first direction D2 is identical to or substantially identical to the length L1 of the p-type thermoelectric conversion element 21. The length of the n-type thermoelectric conversion element 22 in the second direction D3 is, for example, 2 mm or more and 10 mm or less. In this case, a sufficient number of thermoelectric conversion parts 11 can be formed on the first main face 2a. The thermal conductivity of the n-type thermoelectric conversion element 22 in the in-plane direction is, for example, 0.01 W/mK or more and 40.0 W/mK or less. The thermal conductivity of the n-type thermoelectric conversion element 22 in the in-plane direction is measured by, for example, an optical alternating current method or a 3-omega method. As same as the p-type thermoelectric conversion element 21, the n-type thermoelectric conversion element 22 is formed by, for example, various dry methods or wet methods.

The n-type thermoelectric conversion element 22 is, for example, an n-type semiconductor layer. The n-type thermoelectric conversion element 22 includes, for example, a composite of a plurality of organic substances or a composite of an inorganic substance and an organic substance. In the present embodiment, the n-type thermoelectric conversion element 22 is a portion that exhibits n-type by including a dopant in the p-type thermoelectric conversion element 21. Therefore, the n-type thermoelectric conversion element 22 includes carbon nanotubes, conductive resins and a dopant. In the present embodiment, dopant means a substance which changes a Seebeck coefficient of a portion to be doped with the dopant. The expression "changing a Seebeck coefficient" means decreasing a Seebeck coefficient value or changing a Seebeck coefficient value from a positive value to a negative value. A thermoelectric conversion material having a positive Seebeck coefficient value has p-type conductivity, and a thermoelectric conversion material having a negative Seebeck coefficient value has an n-type material.

The dopant of the present embodiment, for example, contains: a coordination compound capable of dissociating into an anion that is a complex ion (hereinafter, also simply referred to as "anion") and an alkali metal cation (hereinafter, also simply referred to as "cation"); and a cation scavenger (hereinafter, also simply referred to as "scavenger"). Within the n-type thermoelectric conversion element 22, at least a part of the coordination compound may be dissociated into the anion and the cation. In this case, the cation may be captured by the scavenger. The dopant may contain plural kinds of at least one of a coordination compound and a scavenger. In the portion where the p-type thermoelectric conversion element 21 contains the dopant, the Seebeck coefficient changes. As a result, the n-type thermoelectric conversion element 22 is formed in the above portion.

The reason why the above-described effect is exhibited is not particularly limited, and as one of the causes it is conceivable that the scavenger contained in the dopant captures the cation to dissociate the anion and the anion changes a carrier of the carbon nanotube from a hole to an electron. At this time, in the present embodiment, since the anion is a complex ion having a metal atom at the center, it is conceivable that the n-type conversion is significantly performed by an interaction between the metal atom and the carbon nanotube. It is also conceivable to exhibit the above-described effect because the ionic size of the complex ion is large so that the dissociation of the complex ion from the cation captured by the scavenger is favorable. In the dopant of the present embodiment, the anion is a complex ion. Thus, the n-type thermoelectric conversion element 22 contains the metal atom derived from the complex ion. Therefore, in the present embodiment, the metal atom remaining in the n-type thermoelectric conversion element 22 can function as an antioxidant.

The complex ion (anion) obtained by dissociation of the coordination compound may be selected from the group consisting of ferrocyanide ions, ferricyanide ions, tetrachloroferrate(III) ions, tetrachloroferrate(II) ions, tetracyanonickelate(II) ions, tetrachloronickelate(II) ions, tetracyanocobaltate(II) ions, tetrachlorocobaltate(II) ions, tetracyanocuprate(I) ions, tetrachlorocuprate(II) ions, hexacyanochromate(III) ions, tetrahydroxidozincate(II) ions and tetrahydroxidoaluminate(III) ions. In the above-described group, ferrocyanide ions may be selected. When the anion is ferrocyanide ions, a material having more favorable characteristics is obtained. Furthermore, when the anion is a ferrocyanide ion, there are tendencies that the iron atom remaining in the n-type thermoelectric conversion element 22 suitably functions as an antioxidant, that a change in physical properties over time is further suppressed and that the storage stability is further improved.

The anion may include an iron atom. That is, the coordination compound may include the iron atom. In this case, the anion may be selected, for example, from the group consisting of ferrocyanide ions, ferricyanide ions, tetrachloroferrate(III) ions and tetrachloroferrate(II) ions. In view of the characteristics of the n-type thermoelectric conversion element 22, the anion including the iron atom may be ferrocyanide ions. From the viewpoint of the antioxidant effect, the content of the iron atom in the n-type thermoelectric conversion element 22 may be 0.001% by mass or more and 15% by mass or less, may be 0.005% by mass or more and 12% by mass or less, or may be 0.01% by mass or more and 10% by mass or less. The content of the iron atom in the n-type thermoelectric conversion element 22 indicates a value measured by, for example, ICP emission spectrometry.

The coordination compound may be a complex salt. Examples of the complex salt include potassium ferrocyanide, sodium ferrocyanide, potassium ferricyanide, sodium ferricyanide, potassium tetrachloroferrate(III), sodium tetrachloroferrate(III), potassium tetrachloroferrate(II), sodium tetrachloroferrate(II) and the like. The complex salt may be a hydrate.

Examples of the alkali metal cation obtained by dissociation of the coordination compound include a sodium ion, a potassium ion, a lithium ion and the like. The coordination compound preferably includes at least one of a ferrocyanide compound and a ferricyanide compound.

The cation scavenger is not particularly limited as long as it is a substance which is capable of taking in a cation. Examples of the cation scavenger include a crown ether-based compound, cyclodextrin, calixarene, ethylenediaminetetraacetate, porphyrin, phthalocyanine, derivatives thereof and the like. In the present embodiment, the cation scavenger is a crown ether-based compound. Examples of the crown ether-based compound include 15-crown-5-ether, 18-crown-6-ether, 12-crown-4-ether, benzo-18-crown-6-ether, benzo-15-crown-5-ether, benzo-12-crown-4-ether and the like. The ring size of the crown ether used as the scavenger may be selected in accordance with the size of the metal ion to be taken in. For example, in a case where the metal ion is a potassium ion, the crown ether-based compound may be an 18-membered ring crown ether. In a case where the metal ion is a sodium ion, the crown ether-based compound may be a 15-membered ring crown ether. In a case where the metal ion is a lithium ion, the crown ether-based compound may be a 12-membered ring crown ether.

The crown ether-based compound may contain a benzene ring. In this case, the stability of the crown ether-based compound may be improved. Examples of the crown ether-based compound having a benzene ring include benzo-18-crown-6-ether, benzo-15-crown-5-ether, benzo-12-crown-4-ether and the like.

A molar ratio (CA₂/CA₁) of a content CA₂ of the scavenger with respect to a content CA₁ of the cation may be 0.1 or more and 5 or less, 0.3 or more and 3 or less, or 0.5 or more and 2 or less.

In each of the plurality of thermoelectric conversion parts 11, a mass percentage of the carbon nanotubes in the total mass of the thermoelectric conversion part 11 is, for example, 30% or more and 70% or less. When the mass percentage is 30% or more, the thermoelectric conversion part 11 can have excellent electrical conductivity. When the mass percentage is 70% or less, the temperature difference in the thermoelectric conversion part 11 tends to be large. The mass percentage may be 35% or more, 40% or more, 45% or more, or 50% or more. The mass percentage may be 65% or less, 60% or less, or 55% or less. The mass percentage of the carbon nanotubes in the total mass of the p-type thermoelectric conversion element 21 may be 30% or more and 70% or less, and the mass percentage of the carbon nanotubes in a total mass of the n-type thermoelectric conversion element 22 may be 30% or more and 70% or less. In each of the plurality of thermoelectric conversion groups 3, the mass percentage of the carbon nanotubes in the total mass of the thermoelectric conversion group 3 may be 30% or more and 70% or less, or 40% or more and 60% or less. The internal temperature difference of the thermoelectric conversion part 11 or the like is measured using, for example, a thermography.

Each of the plurality of conductive parts 4 is a conductive part located on the first main face 2a and is connected to the corresponding thermoelectric conversion group 3. Each conductive part 4 may be a semiconductor instead of a conductor. The thickness of each conductive part 4 is identical or substantially identical to the thickness T1 of the p-type thermoelectric conversion element 21. The conductivity of each conductive part 4 may be equal to or higher than the conductivity of the p-type thermoelectric conversion element 21. The thermal conductivity of each conductive part 4 may be equal to or higher than the thermal conductivity of the p-type thermoelectric conversion element 21. At least a part of the plurality of conductive parts 4 may have a single-layer structure or a laminated structure. For example, at least a part of the plurality of conductive parts 4 may have an organic conductive layer and a metal conductive layer located on the organic conductive layer. In the present embodiment, the plurality of conductive parts 4 are formed of the identical material as the p-type thermoelectric conversion element 21. Therefore, each conductive parts 4 has identical conductivity type (p-type).

The plurality of conductive parts 4 include a first conductive part 4a functioning as a terminal connected to the external device and a second conductive part 4b functioning as a conductive path connecting the adjacent thermoelectric conversion groups 3 to each other. The plurality of conductive parts 4 have two first conductive parts 4a located in the one conductive region R2. In a plan view, one first conductive part 4a is provided around the opening O1 of the substrate 2, and the other first conductive part 4a is provided around the opening O2 of the substrate 2.

Only the second conductive parts 4b are provided in the other conductive region R2. The plurality of thermoelectric conversion groups 3 are connected in series to each other via a plurality of second conductive parts 4b. Thus, when the thermoelectric conversion module 1 is performing thermoelectric conversion, current can flow in series from one first conductive part 4a to the other first conductive part 4a. For example, one first conductive part 4a located in one conductive region R2 is connected to one end of the thermoelectric conversion group 3 in the first direction D2. One second conductive part 4b located in the other conductive region R2 is connected to the other end of the thermoelectric conversion group 3 in the first direction D2.

The plurality of thermal conduction parts 5 are portions exhibiting higher thermal conductivity than the substrate 2, and are located on the second main face 2b. Each thermal conduction part 5 is directly or indirectly fixed to the second main face 2b. Therefore, each thermal conduction part 5 is arranged to be thermally exchangeable with the thermoelectric conversion group 3 (i.e., the thermoelectric conversion part 11) via the substrate 2. In the present embodiment, even if the thermal conduction part 5 is fixed to the second main face 2b via an adhesive or the like, the thermal conduction part 5 is considered to be in contact with the second main face 2b. In the thickness direction D1, the substrate 2, the thermoelectric conversion group 3, and the thermal conduction part 5 overlap each other. Here, at least a part of the plurality of thermal conduction parts 5 overlaps the thermoelectric conversion group 3 (i.e., the thermoelectric conversion part 11) in the thickness direction D1. More specifically, at least a part of the plurality of thermal conduction parts 5 overlaps an end of the thermoelectric conversion part 11. On the other hand, each thermal conduction part 5 does not overlap the center of the thermoelectric conversion part 11. Accordingly, a temperature gradient inside the thermoelectric conversion part 11 along the first direction D2 can be favorably generated. The plurality of thermal conduction parts 5 are spaced apart from each other along the first direction D2 and have a band shape extending along the second direction D3 in a plan view. The shape of each thermal conduction part 5 in a plan view is not particularly limited, and is, for example, a polygonal shape, a circular shape, an elliptical shape or the like.

The length T2 of each thermal conduction part 5 along the thickness direction D1 is, for example, 50 µm or more and 2000 µm or less. The width L2 of each thermal conduction part 5 along the first direction D2 is, for example, 0.5 mm or more and 2.0 mm or less. In these cases, the thermal conduction function of each thermal conduction part 5 can be favorably exhibited. In two adjacent thermal conduction parts 5, the interval S along the first direction D2 is greater than the length L1 of the p-type thermoelectric conversion element 21 in the first direction D2 and the length of the n-type thermoelectric conversion element 22 in the first direction D2, and is 3 mm or more and 15 mm or less. The interval S may be greater than or equal to 4 mm, greater than or equal to 5 mm, greater than or equal to 6 mm, less than or equal to 12 mm, less than or equal to 10 mm, or less than or equal to 8 mm. Alternatively, the interval S may be less than 12 mm or less than 10 mm.

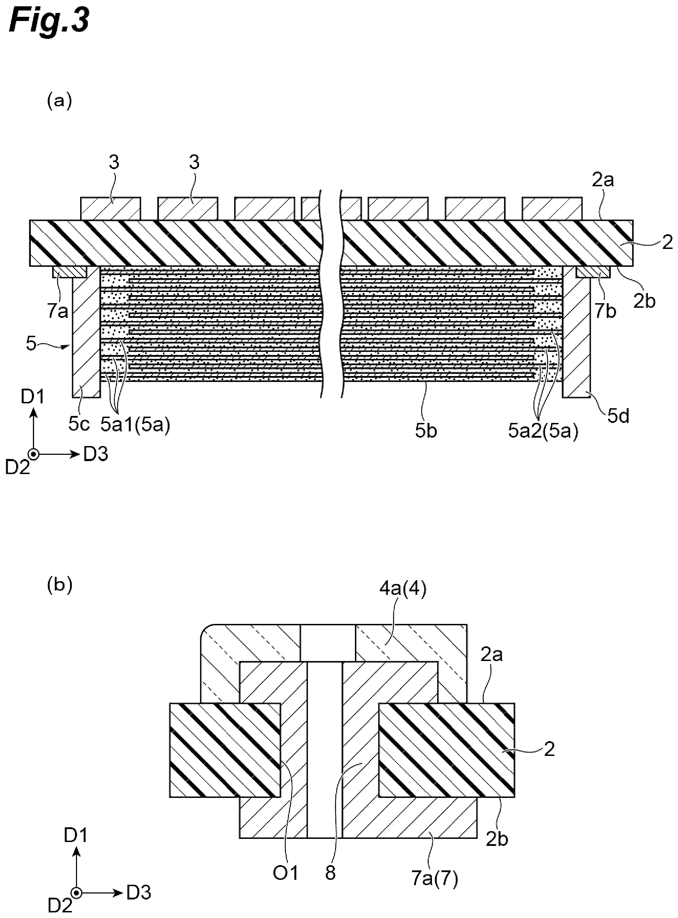

(a) of FIG. 3 is a cross-sectional view taken along line IIIa-IIIa of (a) of FIG. 1. As shown in (a) of FIG. 3, the thermal conduction part 5 is a laminated capacitor located on the second main face 2b. The capacitor is a member for storing power generated by the thermoelectric conversion part 11. The thermal conduction part 5 is in contact with the second main face 2b and electrically connected to the thermoelectric conversion part 11. The thermal conduction part 5, which is a capacitor, includes a plurality of internal electrodes 5a stacked each other in the thickness direction D1, a dielectric 5b filling the gaps between the plurality of internal electrodes 5a, an external electrode 5c connected to the first internal electrode 5a1 included in the plurality of internal electrodes 5a, and an external electrode 5d connected to the second internal electrode 5a2 included in the plurality of internal electrodes 5a.

Each of the plurality of internal electrodes 5a is, for example, a sheet-like conductive member having a band shape in a plan view. The greater the number of internal electrodes 5a, the better the power storage performance of the capacitor, which is the thermal conduction part 5. From the viewpoint of power storage, the number of internal electrodes 5a included in the thermal conduction part 5 is, for example, 2 or more and 30 or less. The interval between adjacent internal electrodes 5a is adjusted according to the length T2 of the thermal conduction part 5 and the number of internal electrodes 5a. The material constituting the internal electrodes 5a includes conductive materials generally used as internal electrodes of laminated capacitors (for example, Al, Ni, Cu, etc.). Each internal electrode 5a is, for example, a vapor-deposited material, a coated and dried material, or a sintered material of the above conductive materials. In the plurality of internal electrodes 5a, the first internal electrode 5a1 and the second internal electrode 5a2 are spaced apart from each other and alternately stacked along the thickness direction D1. Each first internal electrode 5a1 extends from the external electrode 5c toward the external electrode 5d in the second direction D3. Each first internal electrode 5a1 is in contact with the external electrode 5c and spaced apart from the external electrode 5d. Each second internal electrode 5a2 extends from the external electrode 5d toward the external electrode 5c in the second direction D3. Each second internal electrode 5a2 is in contact with the external electrode 5d and spaced apart from the external electrode 5c.

The dielectric 5b is the main body of the thermal conduction part 5 and is a member having insulation and heat resistance. The dielectric 5b is a laminate of a plurality of dielectric layers. Each dielectric layer is integrated with each other. At this time, each dielectric layer may be integrated to the extent that the boundaries between them are not visible. Each dielectric layer is provided with either the first internal electrode 5a1 or the second internal electrode 5a2. The plurality of internal electrodes 5a are formed by alternately stacking the dielectric layers provided with the first internal electrode 5a1 and the dielectric layers provided with the second internal electrode 5a2.

From the viewpoints of maintaining the power storage performance of the capacitor during exhibiting the function of the thermal conduction part 5, of preventing damage to the capacitor and the like, the dielectric 5b may be composed of a heat-resistant inorganic solid or a composite material of the inorganic solid and a heat-resistant resin. Heat resistance refers to the property of maintaining the original state (solid state) without melting or decomposing at the following heat resistance temperature. The heat resistance temperature is at least 120°C, may be 150°C, or may be 180°C. In this case, even if the thermoelectric conversion module 1 is placed in a high-temperature environment, the function of the capacitor, which is the thermal conduction part 5, can be favorably exhibited. On the other hand, film capacitors having a resin that does not exhibit heat resistance, such as polypropylene, and aluminum electrolytic capacitors may be damaged in a high-temperature environment. Therefore, it can be said that film capacitors, aluminum electrolytic capacitors and the like cannot be used as the thermal conduction part 5 according to the present embodiment.

The heat-resistant inorganic solid is, for example, a dielectric material of the BaTiO₃-based, Ba(Ti, Zr)O₃-based, or (Ba, Ca)TiO₃-based. When the dielectric 5b is composed of an inorganic solid, the dielectric 5b is, for example, composed of a sintered body of a ceramic green sheet containing the above dielectric material. This sintered body is a sintered body of a laminate of ceramic green sheets (i.e., a sintered body of a plurality of dielectric layers stacked on each other). In this case, the dielectric constant of the dielectric 5b can be increased, thereby improving the power storage performance of the capacitor.

When the dielectric 5b is composed of a composite material of an inorganic solid and a heat-resistant resin, the dielectric 5b is, for example, composed of a heat-resistant resin in which particles of the above inorganic solid are dispersed. In this case, the dielectric 5b exhibits good flexibility, so the thermal conduction part 5 is less likely to be damaged even if the thermoelectric conversion module 1 is deformed. In addition, since the particles of the inorganic solid are dispersed, the thermal conductivity of the dielectric 5b can be improved. From the viewpoint of dielectric constant, thermal conductivity, and the like, the heat-resistant resin is, for example, a silicone resin. From the viewpoint of preventing the loss of the inorganic solid and the dielectric constant of the dielectric 5b, the mass ratio of the inorganic solid to the heat-resistant resin (inorganic solid: heat-resistant resin) in the composite material is, for example, 20:80 to 90:10.

The external electrode 5c is one of the external terminals of the capacitor and covers one end of the dielectric 5b in the second direction D3. The external electrode 5c is in contact with all the first internal electrodes 5a1. The external electrode 5d is another external terminal of the capacitor and covers the other end of the dielectric 5b in the second direction D3. The external electrode 5d is in contact with all the second internal electrodes 5a2. Each of the external electrodes 5c and 5d may have a single-layer structure or a multi-layer structure. Each of the external electrodes 5c and 5d includes, for example, a sintered layer, a plating layer, and the like. The sintered layer at least includes, for example, metal such as Cu, Ni, Ag, or the like. The plating layer is, for example, a Ni plating layer or the like.

From the viewpoint of the thermal conduction function of the thermal conduction part 5, the thermal conductivity of the thermal conduction part 5 in the thickness direction D1 may be 3 W/mK or more, 5 W/mK or more, or 10 W/mK or more. Accordingly, when the thermoelectric conversion module 1 is heated, heat is favorably transferred to the thermoelectric conversion part 11 via the plurality of thermal conduction parts 5. In addition, a part of the thermoelectric conversion part 11 can be quickly dissipated via the plurality of thermal conduction parts 5. The thermal conductivity of the thermal conduction part 5 in the thickness direction D1 is measured by, for example, an optical alternating current method or a 3-omega method. From the viewpoint of the thermal conduction function of the thermal conduction part 5, each of the thermal conductivity of the internal electrodes 5a, the thermal conductivity of the dielectric 5b, and the thermal conductivity of the external electrodes 5c and 5d may be 3 W/mK or more. The thermal conductivity may be 5.0 W/mK or more, or 10.0 W/mK or more. Alternatively, when the thermal conductivity of the thermal conduction part 5 in the thickness direction D1 is 3 W/mK or more, any thermal conductivity of the internal electrodes 5a, the dielectric 5b, and the external electrodes 5c and 5d may be less than 3 W/mK.

The plurality of thermal insulating members 6 are portions exhibiting thermal conductivity equal to or lower than that of the substrate 2, and are located on the second main face 2b. Each of the plurality of thermal insulating members 6 is located between the corresponding two thermal conduction parts 5 in the first direction D2. The plurality of thermal insulating members 6 are spaced apart from each other along the first direction D2. The shape of each thermal insulating member 6 in a plan view is not particularly limited, and is, for example, a polygonal shape, a circular shape, an elliptical shape or the like. In the present embodiment, each thermal insulating member 6 has a band shape extending along the second direction D3 in a plan view and is in contact with both the corresponding two thermal conduction parts 5. Therefore, the width of each thermal insulating member 6 along the first direction D2 in the present embodiment corresponds to the interval S. In addition, both ends of the thermal insulating member 6 in the second direction D3 are aligned with both ends of the thermal conduction part 5, but are not limited thereto. The length T3 of each thermal insulating member 6 along the thickness direction D1 is smaller than the length T2 of each thermal conduction part 5. For example, the length T3 is 80% or less, or 70% or less of the length T2. In this case, the thermal insulating member 6 is less likely to peel off from the substrate 2 when the thermoelectric conversion module 1 is deformed.

At least a part of each of the plurality of thermal insulating members 6 overlaps the center of the corresponding thermoelectric conversion part 11 in the thickness direction D1. In other words, in each thermoelectric conversion part 11, the first end part 21a of the p-type thermoelectric conversion element 21 and the first end part 22a of the n-type thermoelectric conversion element 22 overlap at least a part of the corresponding thermal insulating member 6 in the thickness direction D1. Accordingly, the temperature at the center part of each thermoelectric conversion part 11 can be stabilized, so that a temperature gradient inside the thermoelectric conversion part 11 along the first direction D2 tends to be stably generated. Therefore, the variation range of the temperature difference inside each thermoelectric conversion part 11 during a predetermined period can be, for example, 2.5°C or less, 2.0°C or less, or 1.0°C or less. The variation range of the temperature difference of the thermoelectric conversion part 11 can be obtained by measuring the temporal change of each of the high-temperature region (for example, one of the center and the both end parts of the thermoelectric conversion part 11 in the first direction D2) and the low-temperature region (for example, the other of the center and the both end parts of the thermoelectric conversion part 11 in the first direction D2) of the thermoelectric conversion part 11. The predetermined period is not particularly limited, but is, for example, 10 seconds or more and 100 hours or less.

Each thermal insulating member 6 includes, for example, cellulose nanofiber (CNF), silica aerogel, resin (for example, silicone resin) and the like. Each thermal insulating member 6 may be a foam. The thermal conductivity of each thermal insulating member 6 is, for example, 0.01 W/mK or more and 0.1 W/mK or less. The thermal conductivity may be 0.02 W/mK or more, 0.03 W/mK or more, 0.08 W/mK or less, or 0.05 W/mK or less. In the present embodiment, the thermal conductivity of each thermal insulating member 6 is, for example, 0.02 W/mK or more and 0.05 W/mK or less, but is not limited thereto.

Here, one of the two thermal conduction parts 5 (the first thermal conduction part) shown in (a) of FIG. 2 is referred to as the first capacitor C1, and the other thermal conduction part 5 (the second thermal conduction part) located adjacent to the first capacitor C1 with the thermal insulating member 6 therebetween along the first direction D2 is referred to as the second capacitor C2. In this case, in the thickness direction D1, the first capacitor C1 overlaps one end of one thermoelectric conversion part 11 in the first direction D2, and the second capacitor C2 overlaps the other end of the one thermoelectric conversion part 11 in the first direction D2. More specifically, in the thickness direction D1, the first capacitor C1 overlaps the second end part 22b of the n-type thermoelectric conversion element 22 included in the one thermoelectric conversion part 11, and the second capacitor C2 overlaps the second end part 21b of the p-type thermoelectric conversion element 21 included in the one thermoelectric conversion part 11.

The connection part 7 is a conductive member electrically connected to both the thermoelectric conversion part 11 and the thermal conduction part 5 and is located on the substrate 2. A part of the connection part 7 overlaps the thermal conduction part 5 or the thermal insulating member 6 in the thickness direction D1 and is located between the substrate 2 and the thermal conduction part 5 or the thermal insulating member 6. The connection part 7 is, for example, a metal layer or an alloy layer patterned on the substrate 2. The metal included in the connection part 7 is, for example, Cu, Ni, Au or the like. The connection part 7 is formed by, for example, plating or the like. The thermal conductivity of the connection part 7 is not particularly limited, but may be 3 W/mK or more.

The connection part 7 includes a first portion 7a in contact with the substrate 2 and overlapping one end of each thermal conduction part 5 in the second direction D3, and a second portion 7b in contact with the substrate 2 and overlapping the other end of each thermal conduction part 5 in the second direction D3. In the present embodiment, the first portion 7a is in contact with the external electrode 5c of each thermal conduction part 5, and the second portion 7b is in contact with the external electrode 5d of each thermal conduction part 5. Therefore, each thermal conduction part 5 (capacitor) is connected in parallel to each other via the first portion 7a and the second portion 7b.

(b) of FIG. 3 is a cross-sectional view taken along line IIIb-IIIb of (a) of FIG. 1. As shown in (b) of FIG. 3, a conductive material 8 is provided on the surface of the opening O1. The conductive material 8 is a conductive member functioning as a path for electrically connecting the thermoelectric conversion part 11 and the thermal conduction part 5 and covers the opening O1. The conductive material 8 is formed, for example, simultaneously with the connection part 7. Therefore, the conductive material 8 is considered to be a part of the first portion 7a of the connection part 7. In the present embodiment, the conductive material 8 is also formed on the first main face 2a in the vicinity of the opening O1, but is not limited thereto. A conductive member connected to the conductive material 8 may be provided on the first main face 2a. Although not shown, a conductive material considered to be a part of the second portion 7b of the connection part 7 is also provided on the surface of the opening O2.

The thermoelectric conversion module 1 may further include configurations other than those described above. For example, the thermoelectric conversion module 1 may include wiring for electrically connecting another thermoelectric conversion module, wiring for taking out power to an external circuit, and the like.

In the thermoelectric conversion module 1 according to the present embodiment described above, the dielectric 5b exhibits heat resistance. Therefore, unlike the case where, for example, an aluminum electrolytic capacitor or the like is used, it is not necessary to provide the capacitor away from the heat source. Also, the substrate 2, the thermoelectric conversion part 11, and the thermal conduction part 5, which is a capacitor electrically connected to the thermoelectric conversion part 11, overlap each other in the thickness direction D1. This reduces the area occupied by the thermoelectric conversion module and the capacitor compared to a power source where the thermoelectric conversion module and the capacitor are simply arranged side by side. In addition, the thermal conduction part 5 is provided to be thermally exchangeable with the thermoelectric conversion part 11 via the substrate 2, and each of thermal conductivities of the plurality of internal electrodes 5a and the thermal conductivity of the dielectric 5b included in the thermal conduction part 5 is 3 W/mK or more. Therefore, for example, even if the capacitor is located between the thermoelectric conversion part 11 and the heat source in the thickness direction D1, the capacitor can be favorably heated without being damaged, and heat transfer from the heat source to the thermoelectric conversion part 11 via the capacitor can be favorably performed.

In the present embodiment, the thermal conduction part 5 may have flexibility. In this case, for example, the thermoelectric conversion module 1 can be easily provided along the surface of a cylindrical pipe. That is, the restriction on the mounting location of the thermoelectric conversion module 1 can be relaxed.

In the present embodiment, the thermoelectric conversion module 1 includes the thermal insulating member 6 located on the second main face 2b, and the thermoelectric conversion part 11 has the p-type thermoelectric conversion element 21 and the n-type thermoelectric conversion element 22 arranged along the first direction D2, the first end part 21a of the p-type thermoelectric conversion element 21 in the first direction D2 is in contact with the first end part 22a of the n-type thermoelectric conversion element 22 in the first direction D2 and overlaps with the thermal insulating member 6 in the thickness direction D1, the plurality of thermal conduction parts 5 are adjacent to each other with the thermal insulating member 6 therebetween along the first direction D2 and include the first capacitor C1 and the second capacitor C2 in contact with the second main face 2b, in the thickness direction D1, the first capacitor C1 overlaps with the second end part 22b of the n-type thermoelectric conversion element 22 in the first direction D2, and in the thickness direction D1, the second capacitor C2 overlaps with the second end part 21b of the p-type thermoelectric conversion element 21 in the first direction D2. Accordingly, each of the first capacitor C1 and the second capacitor C2 overlaps the end part of the thermoelectric conversion part 11 in the thickness direction D1, while not overlapping the center of the thermoelectric conversion part 11. Therefore, for example, by heating the first capacitor C1 and the second capacitor C2, an internal temperature difference can be favorably generated in each of the p-type thermoelectric conversion element 21 and the n-type thermoelectric conversion element 22.

In the present embodiment, the thermoelectric conversion module 1 includes a connection part 7 located on the second main face 2b and electrically connected to both the thermoelectric conversion part 11 and the thermal conduction part 5, which is a capacitor. Therefore, the thermoelectric conversion part 11 and the capacitor are favorably electrically connected.

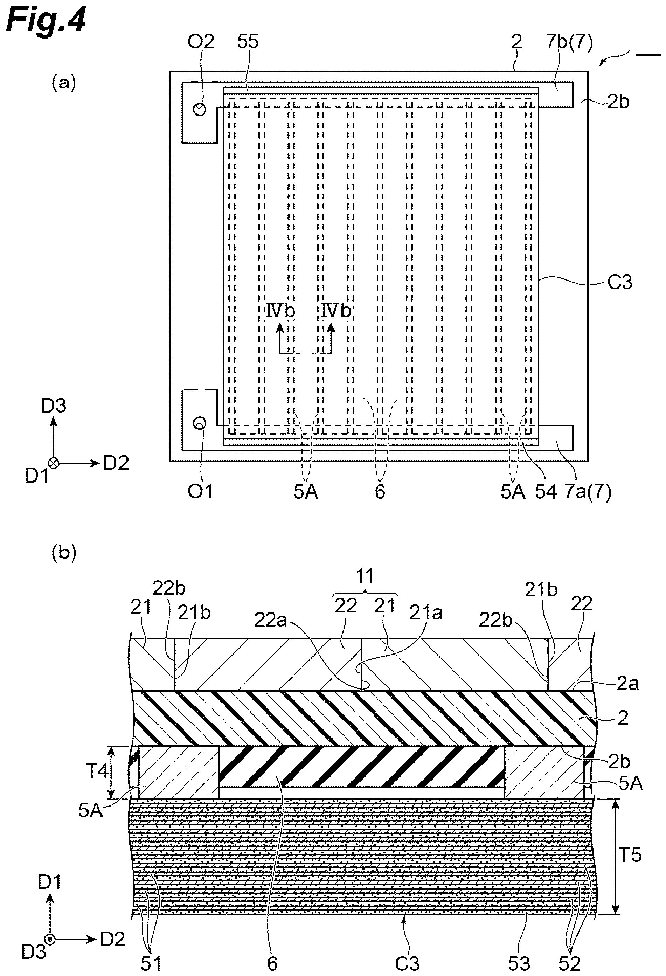

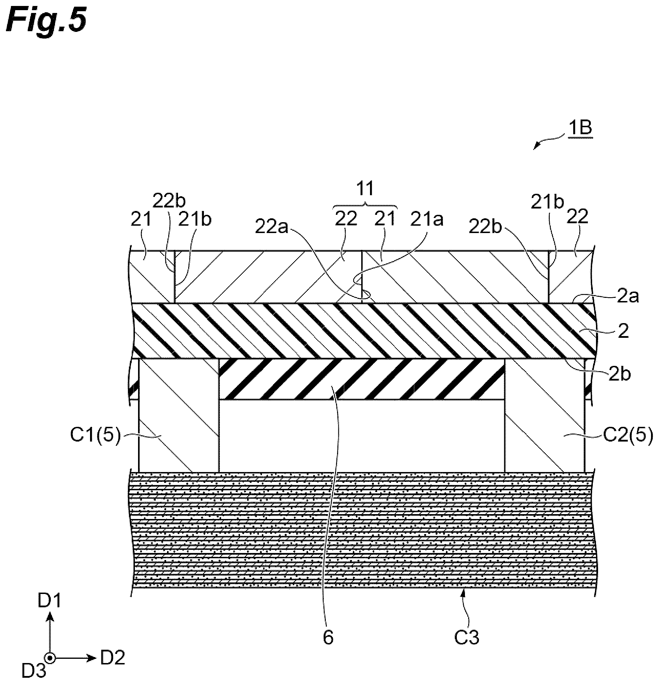

Next, a thermoelectric conversion module according to a modification will be described with reference to FIGS. 4 and 5. In the description of the modification, redundant descriptions overlapping with the above-described embodiment are omitted, and different parts are described. That is, within the technically possible range, the descriptions of the above-described embodiment may be appropriately used in the modification.

(a) of FIG. 4 is a schematic bottom view illustrating a thermoelectric conversion module according to a first modification, and (b) of FIG. 4 is a cross-sectional view taken along line IVb-IVb of (a) of FIG. 4. As shown in (a) and (b) of FIG. 4, the thermoelectric conversion module 1A according to the first modification is different from the thermoelectric conversion module 1 of the above-described embodiment in that it includes thermal conduction parts 5A instead of the thermal conduction parts 5, and further includes a capacitor C3.

Each thermal conduction part 5A is a portion exhibiting higher thermal conductivity than that of the substrate 2 and has a band shape in a plan view. The thermal conductivity of each thermal conduction part 5A is, for example, 3 W/mK or more and 400 W/mK or less. Accordingly, when the thermoelectric conversion module 1 is heated, heat is favorably transferred to the thermoelectric conversion part 11 via the plurality of thermal conduction parts 5A. The thermal conductivity may be 5 W/mK or more, 8 W/mK or more, or 10 W/mK or more. The length T4 of each thermal conduction part 5A along the thickness direction D1 is greater than the length T3 of the thermal insulating member 6 and is, for example, 50 µm or more and 2000 µm or less. Each thermal conduction part 5A includes, for example, metal (silver, copper, or the like.), carbon, resin (for example, silicone resin, epoxy-based resin, (meth)acrylic-based resin) and the like. Each thermal conduction part 5 may include a ceramic such as boron nitride, aluminum nitride or the like that exhibits high thermal conductivity. In the present embodiment, from the viewpoint of manufacturing efficiency, the thermal conduction part 5A may include the above resin. In this case, the thermal conduction part 5A may be formed using the resin or a solution containing the resin.

The capacitor C3 is thermally exchangeable with the thermoelectric conversion part 11 via the substrate 2 and at least one of the plurality of thermal conduction parts 5A, and exhibits flexibility. Therefore, the capacitor C3 can also function as a thermal conduction part. The capacitor C3 is a sheet capacitor overlapping each thermal conduction part 5A and each thermal insulating member 6 in the thickness direction D1 and electrically connected to the thermoelectric conversion part 11. The capacitor C3 is in contact with each thermal conduction part 5A and spaced apart from the thermal insulating member 6. Therefore, a space is provided between the capacitor C3 and the thermal insulating member 6 in the thickness direction D1. In the first modification, the capacitor C3 is in close contact with the thermal conduction parts 5A.

The length T5 of the capacitor C3 along the thickness direction D1 is, for example, 50 µm or more and 2000 µm or less. In a plan view, the capacitor C3 is located inside the edges of the substrate 2, but is not limited thereto. The thermal conductivity of the capacitor C3 in the thickness direction D1 is preferably 3 W/mK or more, 5 W/mK or more, or 10 W/mK or more. Accordingly, when the thermoelectric conversion module 1A is heated, heat is favorably transferred to the thermoelectric conversion part 11 via the capacitor C3 and each thermal conduction part 5A. In addition, a part of the thermoelectric conversion part 11 can be quickly dissipated via the capacitor C3 and each thermal conduction part 5A.

The capacitor C3 includes a plurality of first internal electrodes 51 and second internal electrodes 52 stacked each other in the thickness direction D1, a dielectric 53, and a pair of external electrodes 54 and 55 electrically connected to the thermoelectric conversion part 11. The functions, materials and the like of the plurality of first internal electrodes 51 and the plurality of second internal electrodes 52 are the same as those of the first internal electrode 5a1 and the second internal electrode 5a2 included in the capacitor of the above-described embodiment. The functions, materials and the like of the dielectric 53 are also the same as those of the dielectric 5b included in the capacitor of the above-described embodiment. In the first modification, from the viewpoint of flexibility of the capacitor C3, the dielectric 53 is composed of a heat-resistant resin in which particles of an inorganic solid are dispersed. When the thermal conduction part 5A includes a resin, the resin may be identical to at least a part of the resin included in the dielectric 53. In this case, the capacitor C3 can be favorably in close contact to the thermal conduction part 5A by integrating the resins.

The functions, materials and the like of the external electrodes 54 and 55 are the same as those of the external electrodes 5c and 5d included in the capacitor of the above-described embodiment. The external electrode 54 is in contact with another some electrodes included in each first internal electrode 51 and electrically connected to the first portion 7a of the connection part 7. The external electrode 55 is in contact with each second internal electrode 52 and electrically connected to the second portion 7b of the connection part 7. The external electrode 54 may be electrically connected to the first portion 7a via solder, via a wire or the like, or may be directly connected to the first portion 7a. Similarly, the external electrode 55 may be electrically connected to the second portion 7b via solder, via a wire or the like, or may be directly connected to the second portion 7b.

From the viewpoint of the thermal conduction function of the capacitor C3, each of the thermal conductivities of the first internal electrodes 51, the second internal electrodes 52, the dielectric 53, and the external electrodes 54 and 55 may be 3 W/mK or more. The thermal conductivity may be 5.0 W/mK or more, or 10.0 W/mK or more.

Also in the thermoelectric conversion module 1A according to the first modification described above, the same operations and effects as those of the above-described embodiment can be achieved. In addition, by using the capacitor C3, the power storage capacity of the thermoelectric conversion module 1A can be increased.

FIG. 5 is a cross-sectional view of a main part of a thermoelectric conversion module according to a second modification. As shown in FIG. 5, the thermoelectric conversion module 1B according to the second modification includes the capacitor C3, which is a sheet capacitor shown in the first modification, in addition to the thermoelectric conversion module 1 of the above-described embodiment. The capacitor C3 overlaps the thermal insulating member 6, the first capacitor C1, and the second capacitor C2 in the thickness direction D1, is in contact with the first capacitor C1 and the second capacitor C2, and is spaced apart from the thermal insulating member 6. The capacitor C3 is electrically connected to the thermoelectric conversion part 11 in the same manner as in the first modification. In addition, the capacitor C3 is connected in parallel with the plurality of thermal conduction parts 5 including the first capacitor C1 and the second capacitor C2.

In the thermoelectric conversion module 1B according to the second modification described above, the same operations and effects as those of the above-described embodiment can be achieved, and in addition, the power storage capacity of the thermoelectric conversion module 1B can be further increased compared to the first modification.

The thermoelectric conversion module and the manufacturing method thereof according to the present disclosure are not limited to the above-described embodiment and modifications, and various other modifications are possible.

In the above-described embodiment and modifications, the thermoelectric conversion element is exposed on the first main face, but the present disclosure is not limited thereto. For example, the thermoelectric conversion element may be covered with a resinous sealing layer or the like. In addition, an insulator may be provided between two adjacent thermoelectric conversion groups. In this case, from the viewpoint of maintaining the internal temperature difference of the thermoelectric conversion part, the thermal conductivity of the insulator is preferably low.

In the above-described embodiment and modifications, the thermal insulating member is formed by drying a thermal insulating material coating on the substrate, but is not limited thereto. For example, the thermal insulating member formed in advance may be fixed on the substrate.

### Reference Signs List

1, 1A, 1B; thermoelectric conversion module
2; substrate
2a; first main face
2b; second main face
3; thermoelectric conversion group
4; conductive part
5, 5A; thermal conduction part
5a; internal electrode
5a1; first internal electrode
5a2; second internal electrode
5b; dielectric
5c, 5d; external electrode
6; thermal insulating member
7; connection part
7a; first portion
7b; second portion
8; conductive material
11; thermoelectric conversion part
21; p-type thermoelectric conversion element
21a; first end part
21b; second end part
22; n-type thermoelectric conversion element
22a; first end part
22b; second end part
51; first internal electrode
52; second internal electrode
53; dielectric
54, 55; external electrode
C1; first capacitor (first thermal conduction part)
C2; second capacitor (second thermal conduction part)
C3; capacitor (sheet capacitor)
D1; thickness direction
D2; first direction
D3; second direction
L1; length
L2; width
O1, O2; opening
R1; thermoelectric conversion region
R2; conductive region
S; interval
T1; thickness
T2, T3, T4, T5; length.

## Claims

1. A thermoelectric conversion module comprising:
a substrate having a first main face and a second main face located opposite the first main face;
a thermoelectric conversion part located on the first main face; and
a capacitor provided on the second main face, thermally exchangeable with the thermoelectric conversion part via the substrate, and electrically connected to the thermoelectric conversion part,
wherein the substrate, the thermoelectric conversion part, and the capacitor overlap each other in a thickness direction of the substrate, and
wherein the capacitor includes a plurality of electrodes stacked each other in the thickness direction and a dielectric filling gaps between the plurality of electrodes and having heat resistance.

2. The thermoelectric conversion module according to claim 1,
wherein the capacitor has flexibility.

3. The thermoelectric conversion module according to claim 1 or 2, further comprising a thermal insulating member located on the second main face,
wherein the thermoelectric conversion part has a p-type thermoelectric conversion element and an n-type thermoelectric conversion element arranged along a first direction orthogonal to the thickness direction,
wherein a first end part of the p-type thermoelectric conversion element in the first direction is in contact with a first end part of the n-type thermoelectric conversion element in the first direction and overlaps with the thermal insulating member in the thickness direction,
wherein the capacitor includes a first capacitor and a second capacitor adjacent to each other with the thermal insulating member therebetween along the first direction, the first capacitor and the second capacitor being in contact with the second main face,
wherein, in the thickness direction, the first capacitor overlaps with a second end part of the n-type thermoelectric conversion element in the first direction, and
wherein, in the thickness direction, the second capacitor overlaps with a second end part of the p-type thermoelectric conversion element in the first direction.

4. The thermoelectric conversion module according to claim 3,
wherein the capacitor further comprises a sheet capacitor overlapping the thermal insulating member, the first capacitor and the second capacitor in the thickness direction, the sheet capacitor being electrically connected to the thermoelectric conversion part.

5. The thermoelectric conversion module according to claim 4,
wherein the sheet capacitor is in contact with the first capacitor and the second capacitor, the sheet capacitor being spaced apart from the thermal insulating member.

6. The thermoelectric conversion module according to claim 1 or 2, further comprising:
a thermal insulating member located on the second main face; and
a first thermal conduction part and a second thermal conduction part adjacent to each other with the thermal insulating member therebetween along a first direction orthogonal to the thickness direction,
wherein the thermoelectric conversion part has a p-type thermoelectric conversion element and an n-type thermoelectric conversion element arranged along the first direction,
wherein a first end part of the p-type thermoelectric conversion element in the first direction is in contact with a first end part of the n-type thermoelectric conversion element in the first direction and overlaps with the thermal insulating member in the thickness direction,
wherein, in the thickness direction, the first thermal conduction part overlaps with a second end part of the n-type thermoelectric conversion element in the first direction,
wherein, in the thickness direction, the second thermal conduction part overlaps with a second end part of the p-type thermoelectric conversion element in the first direction, and
wherein the capacitor is thermally exchangeable with the thermoelectric conversion part via the substrate and at least one of the first thermal conduction part and the second thermal conduction part.

7. The thermoelectric conversion module according to claim 6,
wherein the capacitor is a sheet capacitor overlapping the thermal insulating member, the first thermal conduction part and the second thermal conduction part in the thickness direction, and
wherein the sheet capacitor is in contact with the first thermal conduction part and the second thermal conduction part, the sheet capacitor being spaced apart from the thermal insulating member.

8. The thermoelectric conversion module according to claim 1 or 2, further comprising a connection part located on the substrate and electrically connected to both the thermoelectric conversion part and the capacitor.

9. The thermoelectric conversion module according to claim 1 or 2,
wherein each thermal conductivity of the plurality of electrodes and the dielectric is 3 W/mK or more.
